(19) Europäisches Patentamt
European Patent Office
Office européen des brevets

(11) **EP 1 381 852 B1**

(12) **FASCICULE DE BREVET EUROPEEN**

(45) Date de publication et mention
de la délivrance du brevet:
**22.06.2011 Bulletin 2011/25**

(51) Int Cl.:
*G01N 27/00* (2006.01)   *B01L 3/00* (2006.01)
*B81B 3/00* (2006.01)

(21) Numéro de dépôt: **02730368.4**

(22) Date de dépôt: **25.04.2002**

(86) Numéro de dépôt international:
**PCT/FR2002/001419**

(87) Numéro de publication internationale:
**WO 2002/086479 (31.10.2002 Gazette 2002/44)**

(54) **MATRICE DE BIOCAPTEURS ET SON PROCEDE DE FABRICATION**

MATRIX AUS BIOSENSOREN UND VERFAHREN ZU DEREN HERSTELLUNG

BIOSENSOR MATRIX AND METHOD FOR MAKING SAME

(84) Etats contractants désignés:
**AT BE CH CY DE DK ES FI FR GB GR IE IT LI LU
MC NL PT SE TR**

(30) Priorité: **25.04.2001 FR 0105545**

(43) Date de publication de la demande:
**21.01.2004 Bulletin 2004/04**

(73) Titulaire: **CENTRE NATIONAL DE LA RECHERCHE
SCIENTIFIQUE
75794 Paris Cedex 16 (FR)**

(72) Inventeurs:
• **BERGAUD, Christian
F-31000 Toulouse (FR)**
• **BELIER, Benoît,
Résidence d'Ilôt des Cours
F-91400 Orsay (FR)**
• **MARTINEZ, Augustin
F-31650 St Orens (FR)**
• **NICU, Liviu
F-11600 Aragon (FR)**
• **COCHETEAU, Emeline
F-31400 Toulouse (FR)**

(74) Mandataire: **Jacquard, Philippe Jean-Luc et al
Cabinet ORES
36, rue de St Pétersbourg
75008 Paris (FR)**

(56) Documents cités:
WO-A-00/66266     WO-A-95/01559
US-A- 5 189 914     US-A- 5 212 988
US-A- 5 252 294     US-A- 5 631 198

• **DATABASE COMPENDEX [en ligne]
ENGINEERING INFORMATION, INC., NEW YORK,
NY, US; SHIH H T ET AL: "Ultra-shallow raised pn
junctions with self-aligned titanium silicide
contacts formed by boron outdiffusion from
selectively deposited silicon epitaxial layers"
Database accession no. EIX96042938259
XP002189581 & PROCEEDINGS OF THE 1995
MRS SPRING MEETING;SAN FRANCISCO, CA,
USA APR 17-20 1995, vol. 387, 1995, pages
401-406, Mater Res Soc Symp Proc;Materials
Research Society Symposium Proceedings;
Rapid Thermal and Integrated Processing IV 1995
Materials Research Society, Pittsburgh, PA, USA**
• **SEMMACHE B ET AL: "Rapid thermal processing
of piezoresistive polycrystalline silicon films: An
innovative technology for low cost pressure
sensor fabrication" SENSORS AND ACTUATORS
A, ELSEVIER SEQUOIA S.A., LAUSANNE, CH,
vol. 46, no. 1-3, janvier 1995 (1995-01), pages
76-81, XP004303456 ISSN: 0924-4247**

**Description**

La présente invention concerne une matrice de biocapteurs utilisant l'effet piézorésistif ou bien l'effet piézoélectrique pour la détection d'interaction moléculaire spécifique. Elle concerne également son procédé de fabrication.

Il a déjà été proposé, par exemple dans les brevets des Etats-Unis US-5,719,324 et US-6,054,277 de mettre en oeuvre un biocapteur intégré sur une puce semi-conductrice, le biocapteur comprenant un ou plusieurs leviers encastrés à une extrémité.

L'évolution de la technique impose de réaliser un grand nombre de mesures et par conséquent de disposer d'un grand nombre de biocapteurs. Or, les techniques connues ne permettent de réaliser que des biocapteurs individuels, ce qui conduit à des coûts de fabrication élevés qu'il est hautement souhaitable de réduire.

A cet effet, l'invention propose une technique permettant d'intégrer sur un même substrat semi-conducteur un grand nombre de biocapteurs.

L'invention concerne ainsi une Matrice de biocapteurs apte à la détection d'interactions spécifiques d'oligonucléotides (ADN/ADN ; ADN/ARN) ou de protéines (ADN/protéines) ou d'antigènes anticorps et comprenant un substrat en matériau semiconducteur, caractérisée en ce qu'elle présente une surface principale plane (4) ainsi que des cavités ouvertes (8), ménagées à partir d'une surface plane (10) opposée à ladite surface plane (4), et dont chacune présente une structure déformable (40, 50) présentant une pluralité d'éléments sensibles qui sont des piézorésistances (44) ou des éléments piézoélectriques (54) disposés entre le fond (9, $9_1$) desdites cavités (8) et la surface plane (4), et qui sont montés en pont de Wheatstone.

Ces cavités sont ainsi des cavités ouvertes qui débouchent sur la surface opposée à la surface principale plane.

Selon un mode de réalisation préféré, au moins une structure déformable est une membrane.

Alternativement, une structure déformable peut comporter au moins une poutre encastrée à une ou de préférence à deux extrémités, par exemple par mise en oeuvre d'une attaque superficielle localisée.

Le substrat peut être en silicium, et préférentiellement être d'un type présentant une couche enterrée en $SiO_2$ (substrat SOI).

Selon une première variante, au moins une structure déformable intègre au moins un élément sensible piézorésistif.

Selon une deuxième variante, au moins une structure déformable présente au moins un élément sensible piézoélectrique déposé sur le substrat.

Afin de permettre un raccordement électrique, notamment par multiplexage des éléments sensibles, la surface plane présente avantageusement des métallisations.

L'invention concerne également un procédé de fabrication d'une matrice de biocapteurs du type précité, caractérisé en ce qu'il met en oeuvre :

a) la réalisation de dits éléments sensibles en des premiers endroits localisés de la surface principale plane du substrat,
b) la réalisation de dites cavités à partir de deuxième (s) endroits localisés d'une deuxième surface du substrat qui est opposée à la surface principale, pour obtenir des structures déformables comportant au moins un dit élément sensible.

Le procédé peut être caractérisé en ce que lesdits éléments sensibles sont piézorésistifs, en ce que le substrat est en silicium et comporte éventuellement une couche enterrée en silice ($SiO_2$), surmontée d'une couche superficielle monocristaline, en ce que a comporte :

$a_1$) le dépôt d'une couche de masquage sur une première surface du substrat, par exemple sur la couche superficielle monocristalline,
$a_2$) la réalisation d'ouvertures en des premiers endroits localisés de la couche de masquage,
$a_3$) l'implantation d'ions en vue de la réalisation desdits éléments sensibles piézorésistifs,

et en ce que b comporte :

$b_1$) le dépôt d'une couche de masquage sur une deuxième surface du substrat opposée à ladite première surface,
$b_2$) la réalisation d'ouvertures dans les deuxièmes endroits localisés de la couche de masquage,
$b_3$) la réalisation par attaque chimique desdites cavités. Dans le cas d'un substrat pourvu d'une couche enterrée de $SiO_2$ l'attaque peut être poursuivie jusqu'à la couche de $SiO_2$ qui forme une couche d'arrêt, cette couche de $SiO_2$ pouvant être conservée ou bien ultérieurement partiellement enlevée, par exemple pour former une couche de passivation

Alternativement, cette couche de $SiO_2$ peut être entièrement enlevée.

Avantageusement, l'étape $a_3$ met en oeuvre

- $a_{31}$) une implantation d'ions contenant du bore par exemple du fluorure de bore ;
- $a_{32}$) un recuit thermique.

L'étape $a_{31}$ est préférentiellement précédée d'une préamorphisation de la surface du substrat auxdits premiers endroits localisés de la couche de masquage, par exemple par implantation de germanium.

Avantageusement, le procédé met en oeuvre la réalisation d'électrodes de prise de contact électrique pour les éléments sensibles piézorésistifs.

Selon une autre variante, les éléments sensibles sont piézoélectriques et l'étape a comporte le dépôt sur lesdits premiers endroits localisés d'une couche piézoélectrique suivi d'un recuit de cristallisation.

Le procédé met avantageusement en oeuvre la réalisation d'électrodes de prise de contact électrique pour les éléments sensibles piézoélectriques.

D'autres caractéristiques et avantages de l'invention apparaîtront mieux à la lecture de la description qui va suivre donnée à titre d'exemple non limitatif, en liaison avec les dessins dans lesquels :

- les figures 1a, et 1b illustrent un exemple de réalisation d'une matrice selon l'invention, la figure 1b étant un agrandi d'un détail de la figure 1a; la figure 1c illustre un mode de réalisation préférée et la figure 1d illustre le, montage en pont de Wheatstone ;
- les figures 2a à 2e illustrent le procédé de fabrication d'une matrice présentant des éléments sensibles piézorésistifs ; et
- la figure 3 illustre un procédé de réalisation de l'invention dans lesquels les éléments sensibles sont piézoélectriques ;
- les figures 4 à 4f illustrent un autre procédé de fabrication à partir d'un substrat en Si, notamment monocristallin.

L'invention concerne le domaine de la génomique, de la protéomique (puces à ADN, puces à protéines) et plus généralement les biopuces. Elle concerne un dispositif permettant la détection d'interactions spécifiques, d'oligonucléotides (ADN/ADN ; ADN/ARN) ou de protéines (ADN/protéines) ou d'antigènes-anticorps.

Un tel système permet de s'affranchir des techniques de marquage des sondes et donc des systèmes de détection externes par fluorescence ou radioactivité.

Le principe de détection proposé peut être comparé à celui des microbalances à cristal de quartz dans lesquels une variation de la masse induit une variation de la fréquence de résonance et/ou de l'amortissement de la structure en résonance.

Toutefois, la mise en oeuvre dans le cadre de l'invention d'éléments sensibles de faible épaisseur de type piézoélectrique ou préférentiellement piézorésistif permet d'améliorer les performances et notamment la sensibilité par rapport aux microbalances à cristal de quartz, pour lesquels le facteur de qualité Q doit être très élevé pour que la sensibilité soit suffisante.

Dans le cadre de l'invention, les variations de masse à détecter sont consécutives à l'appariement d'ADN cibles (ou d'ARN, de protéines ou tout type d'interaction entre molécules) avec les sondes d'ADN présentes sur l'élément sensible.

La technique selon l'invention permet de mettre en oeuvre sur un même substrat une multitude de structures résonantes indépendantes de dimensions réduites, par exemple quelques microns, et non plus un seul dispositif comme c'est le cas dans l'art antérieur. Cette approche est possible, car les techniques d'élaboration de piézorésistances ultraminces ou de couches piézoélectriques ultraminces sont compatibles avec des technologies silicium, ce qui permet de fabriquer des microstructures résonantes de manière collective et à faible coût.

D'autre part, la réduction des dimensions de ces microstructures, permet de réduire leur masse. Ainsi, plus la masse des structures résonantes est faible, plus l'ajout d'une masse modifie la réponse de ladite structure, et on augmente ainsi la sensibilité du système.

Dans le cadre de la présente invention, on utilise préférentiellement les éléments sensibles piézorésistifs, en particulier des membranes. Ceci présente deux avantages :

1/ En mode statique, lors de la phase d'élaboration de la puce à ADN durant laquelle le matériel biologique est déposé par contact sur les microdispositifs piézorésistifs grâce à un système de dépôt automatisé, les membranes déformables permettent de contrôler très précisément la force d'appui ainsi que la durée durant laquelle cette force est appliquée, ce qui assure un contrôle de la quantité de solution déposée sur le microdispositif. Ce type de contrôle n'est pas possible avec des structures de type poutre encastrée à une extrémité qui sont utilisées dans certains cas pour la détection d'interactions, par exemple une poutre telle que décrite dans le brevet US-5,807,758.

Le système proposé permet de plus, en statique lors de la phase de dépôt, si on utilise des systèmes de dépôt par contact, de connaître la force et le temps d'appui des aiguilles sur les dispositifs où s'effectuent les dépôts. Si on utilise un système de dépôt sans contact (système microfluidique avec éjection de gouttes), le système selon l'invention permet de connaître la quantité de liquide déposé, la masse de la goutte induisant une variation de la contrainte et donc une variation de la piézorésistance (ou un effet piézoélectrique).

Il s'agit d'un point important, car il est ainsi possible d'identifier un défaut d'alignement entre les différentes aiguilles utilisées pour réaliser un dépôt collectif, une usure éventuelle des aiguilles ou bien encore les disparités concernant les temps de contact des différentes pointes, ou bien encore les disparités dans la taille des gouttes, qui existent très souvent dans le cas de systèmes à éjection de gouttes.

Cette possibilité de détection est importante car elle conditionne la qualité des dépôts (volume et donc concentration déposée, et la fiabilité des résultats).

Ce système est compatible avec un contrôle actif du dépôt avec boucle de contre-réaction permettant de corriger les erreurs en fonction de la force et du temps de contact lors du dépôt.

Alternativement, le procédé peut être utilisé pour calibrer les systèmes de dépôt par contact par réglage de la hauteur des pointes, vérification de l'usure et des effets de dérive mécanique du système ou bien encore les effets d'interaction parasites comme les vibrations, ou bien pour calibrer les systèmes de dépôt sans contact pour régler la fréquence d'éjection des gouttes ou bien encore la distance entre la zone d'éjection et la surface du microdispositif.

Un tel dispositif de calibration peut être utilisé avant ou après une série de dépôts dans le cas d'un système avec contact, et après dépôt dans le cas d'un système sans contact.

2/ En mode dynamique, lors de la phase de détection, les membranes permettent d'assurer un découplage mécanique efficace entre les différents monodispositifs résonants.

Ceci permet d'éviter de possibles interactions parasites via le substrat entre les différents modes de résonance de chaque microdispositif. Un tel phénomène est susceptible d'apparaître si les microdispositifs sont disposés à même le substrat de départ.

Ce mode dynamique peut être également utilisé pour la phase de dépôt de la même manière que décrit précédemment sous le point 1/ pour contrôler la qualité des dépôts.

Le procédé de fabrication sera précisé ci-après.

D'un point de vue technologique, il s'agit de fabriquer des membranes (ou des poutres) de dimensions les plus réduites' possibles, ce qui suppose de réduire en conséquence l'épaisseur des piézorésistances. A cet effet, l'invention met en oeuvre une préamorphisation localisée du substrat suivie d'une implantation de bore ou de fluorure de bore notamment à très faible énergie, par exemple 15keV, associée à un recuit thermique rapide. Par exemple un recuit pendant 1 à 10 secondes entre 900 et 1100°C permettent d'obtenir les résultats recherchés.

On obtient ainsi des jonctions $p^+$/n ultraminces qui présentent un caractère piézorésistif.

Dans le cadre de l'application envisagée, les membranes (avantageusement de forme carrée ou rectangulaire, et éventuellement circulaire) sont par exemple en silicium monocristallin, d'épaisseur uniforme (quelques microns à quelques centaines de microns) d'orientation (100) et ont des bords parallèles aux directions <110>. Le substrat est par exemple de type n dosé à $10^{17}$ atomes/cm$^3$. Les piézorésistances (ou jauges piézorésistives) dont la valeur nominale est de l'ordre de 1 kΩ à 10 kΩ (typiquement quelques kΩ par exemple entre 4 et 4,5 kΩ) sont implantées pour leur conférer un dopage, notamment $P^+$, compris entre $10^{18}$ et $10^{19}$ atomes/cm$^3$. La longueur de ces jauges est compris entre 50 microns et quelques centaines de microns (par exemple 50 μ et 500 μ) et leur largeur est comprise entre 10 microns et quelques dizaines de microns (par exemple entre 10 μ et 50 μ, voire 100 μ). L'épaisseur h de la membrane est par exemple comprise entre 2 et 30 μ et est par exemple égale à 15 μ. La membrane est par exemple carrée de côté a = 500 μm. Un montage en pont de Wheatstone permet de compenser la dérive thermique de la résistance en rejetant le mode commun. Une diminution de la dimension des jauges permet d'optimiser la contrainte moyenne vue par la jauge et donc la sensibilité. Cette diminution doit être en rapport avec les tolérances du procédé de fabrication mis en oeuvre, afin de ne pas augmenter indûment la dispersion des valeurs des jauges.

La force appliquée F peut être approximée par la formule suivante (R = R1 = R2 = R3 = R4) pour une membrane carrée en Si monocristallin de côté a et de hauteur h

$$ F = \frac{2\Delta Vs}{Va} \quad \frac{h^2}{\pi_{44} \, 6 \times 0{,}1257(\frac{1}{v} - 1)} $$

ν = 0,26 (coefficient de Poisson)
on obtient pour h = 15 μ, a = 500 μm et Va = 10V
F1 = 4,05 m N pour $\Delta Vs_1$ = 0,534 volt
F2 = 2,60 m N pour $\Delta Vs_2$ = 0,343 volt
et pour une membrane circulaire en silicium monocristallin de hauteur h :

$$ F = \frac{4}{3} \quad \frac{\Delta Vs}{Va} \quad \frac{\pi}{\pi_{44}} \quad \frac{h^2}{(1 - v)} $$

avec $\pi_{44}$ = 138,1 e$^{-11}$ (en Pa$^{-1}$)

$$ \nu = 0{,}26 $$

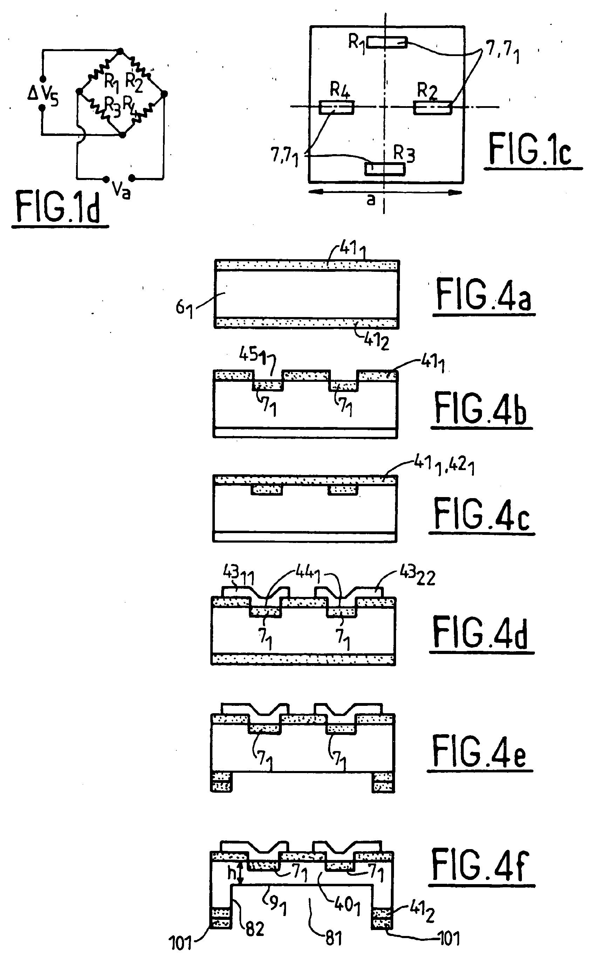

Va = tension appliquée au pont de Wheatstone
ΔVs = différence de tension aux bornes du pont de Wheatstone (voir figure 1d).
Application : h = 15 μ, a = 500 μm, et Va = 10 V,

on a F1 = 32,07 mN pour $\Delta V_{s1}$ = 0,467 volt, et $F_2$ = 12,43 mN pour $\Delta V_{S2}$ = 0,181 volt.

En pratique, on pourra étalonner le capteur en relevant les variation de tension recueillies aux bornes de pont de Wheatstone lorsqu'on applique à la membrane des forces calibrées.

La technique décrite présente l'avantage de conduire à des capteurs piézorésistifs en forme de poutre qui présentent une sensibilité très nettement améliorée par rapport à celles obtenues par les techniques classiques d'implantation de bore qui conduisent à des valeurs de profondeur de jonction' plus importantes.. Cette amélioration vient du fait que la combinaison des deux techniques précitées (préamorphisation et implantation) associées à des techniques de recuit thermique rapide permet de parfaitement confiner la zone piézorésistive à la surface du dispositif où la contrainte mécanique est maximale lors de la déflection, que ce soit en mode statique ou dynamique.

L'intérêt de la technique de l'invention est d'obtenir des piézorésistances ayant une profondeur de jonction très faible notamment entre 50 nm et 200 nm, ou bien entre 50 nm et 100 nm et, par exemple égale à 70 nm, avec un substrat de départ classique en Si par exemple dopé à $10^{17}$ par cm$^3$, dans lequel le bore est implanté avec une énergie de 15keV. Par comparaison, une implantation de bore suivi d'un recuit classique peut donner des profondeurs de jonction de 0,3 à 0,4$\mu$m.

Cette technique d'élaboration de piézorésistrance ultramince, combinant une préamorphisation une implantation de bore ou de BF2 à basse énergie associée à un recuit thermique rapide peut être utilisé pour la fabrication aussi bien de membranes intégrant des capteurs piézorésistifs que de leviers piézorésistifs dans le cadre de la présente invention (parfaitement adaptée également à la microscopie à force atomique).

On notera cependant qu'il est nettement plus intéressant dans le cadre de l'application envisagée d'obtenir une membrane continue, ce qui fait que la face plane du substrat reste étanche et que celui-ci peut être utilisé comme une lame de verre classique, sans qu'il y ait besoin de procéder à des opérations de nettoyage particulières entre deux utilisations successives de la biopuce.

L'invention sera décrite ci-après pour l'obtention d'une matrice de biocapteurs comprenant des membranes par exemple d'épaisseur 5 microns intégrant quatre piézorésistances montées en pont de WHEATSTONE. Sur chaque dispositif peut être disposé un plot d'or, par exemple de 200 microns de diamètre, isolé de manière appropriée des prises de contact électriques, qui permet de localiser les interactions moléculaires (interaction chimique sur l'or avec une chimie de greffage spécifique pour l'or).

Les résonances mécaniques à vide (mode fondamental) des microdispositifs peuvent être mesurés électriquement via les variations des piézorésistances. Un protocole d'étalonnage permet d'effectuer la mesure de la variation de fréquence de résonance consécutivement à l'appariement de brins d'ADN complémentaires, à l'interaction antigène anticorps, ADN/protéines, etc...

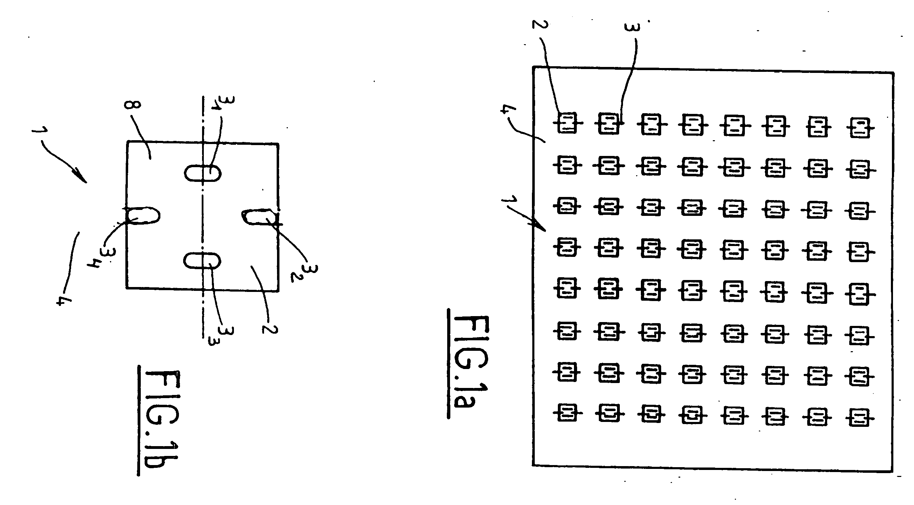

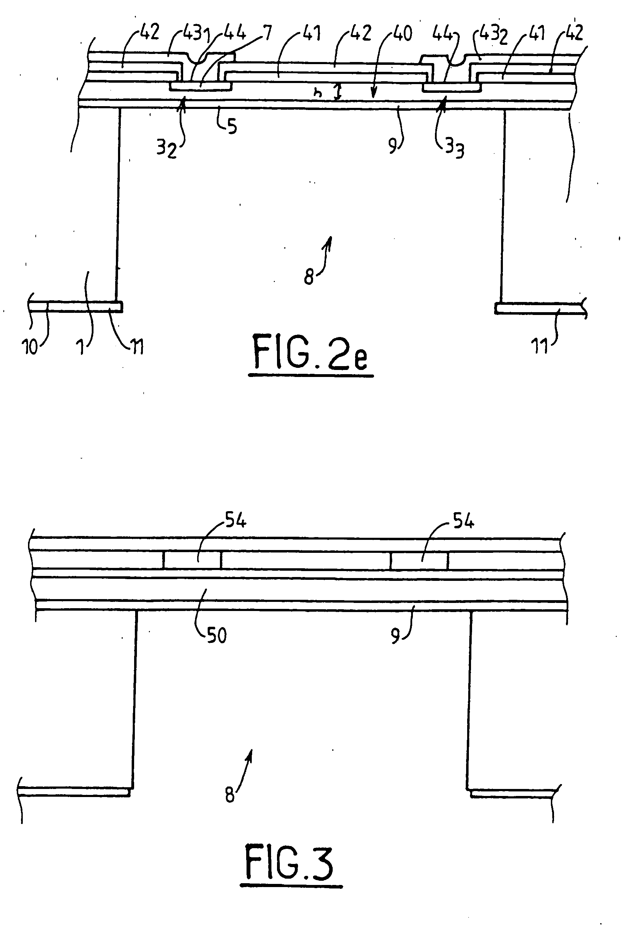

Une matrice de biocapteurs selon l'invention est représentée à la figure 1a. Elle présente un réseau à deux dimensions de biocapteurs dont chacun est composé d'une membrane 2 et d'une pluralité d'éléments sensibles piézorésistifs ou piézoélectriques. Comme le montre plus particulièrement la figure 1b, les éléments sensibles référencés $3_1$, $3_2$, $3_3$ et $3_4$ sont disposés de manière à permettre une détection lorsqu'ils sont connectés en pont de WHEATSTONE. Chacune des membranes 2 est délimitée entre la face principale plane référencée 4 du substrat 1 et le fond 9 de la cavité ouverte à sa partie supérieure (dans sa configuration d'utilisation qui est inversée par rapport à celle qui est représentée pour illustrer le procédé de fabrication), qui est réalisée dans le substrat (voir la figure 2e). Dans le mode préféré qui est représenté à la figure 1c, les jauges R1 à R4 ayant la même résistance sont situées au milieu de chaque bord d'une membrane carrée (ou rectangulaire) de côté a, de sorte que les jauges se trouvent dans les zones de contrainte maximale et les réponses des jauges sont en valeur absolue identiques. Les variations des résistances R2 et R4 d'une part et R1 et R3 d'autre part ont des signes opposés, d'où le montage électrique du pont de Wheastone à la figure 1d. Cette configuration minimise les contraintes thermodynamiques engendrées par les interconnexions pour la membrane.

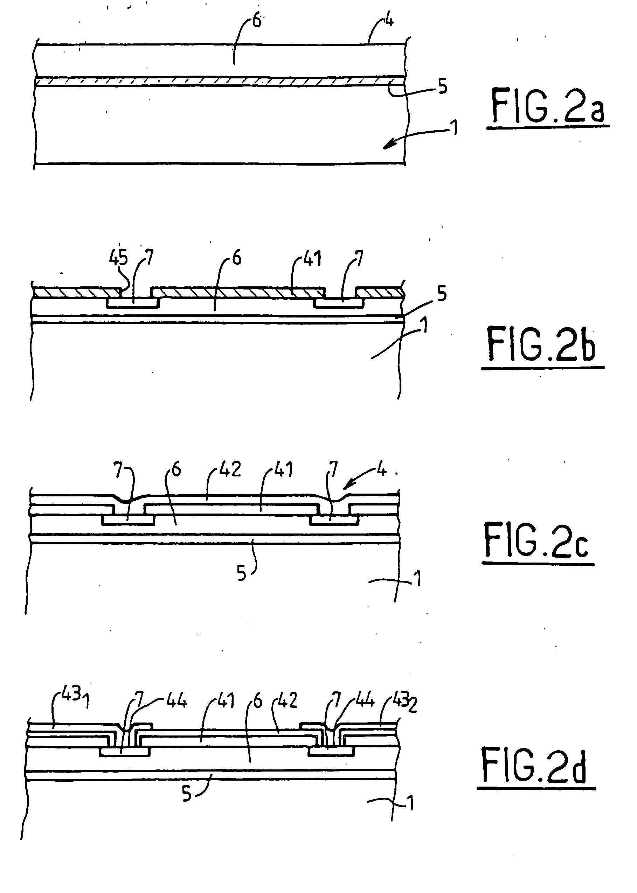

Un procédé de fabrication pour la mise en oeuvre d'éléments sensibles piézorésistifs sera maintenant décrit en liaison avec les figures 2a à 2f, à partir d'un substrat de départ 1 qui présente une couche enterrée 5 en SiO$_2$ surmontée d'une couche superficielle 6 dont l'épaisseur est de quelques microns (pour un substrat de type SOI), et qui peut être inférieure à un micron pour un substrat de type SIMOX.

A la figure 2b, on dépose à la surface du substrat une couche d'oxyde 41 dans laquelle on ménage des ouvertures 45 qui vont permettre de réaliser les piézorésistances. On réalise tout d'abord une première implantation (optionnelle) de germanium pour préamorphiser localement la couche superficielle 6. Ensuite, on implante du bore B ou du BF2 à une densité de $10^{14}$ par cm$^2$ (par exemple pour réaliser les zones 7 constituant les piézorésistances). On réalise ensuite, par exemple à l'aide d'une lampe halogène, un recuit thermique rapide (RTA) d'une durée de quelques secondes à quelques dizaine de secondes entre 900 et 1100°C, ce traitement rapide étant éventuellement suivi d'un recuit classique à plus basse température, par exemple pendant 20 minutes à 800°C, l'association de ces traitements permettant d'activer électriquement les atomes de bores (ou de BF2) implantés et de réduire les défauts créés lors de l'implantation ionique.

Le substrat est ensuite passivé (figure 2c) par dépôt d'une couche d'oxyde 42, par exemple un dépôt à froid de type chimique en phase vapeur sous plasma ("PECVD" ou "LPCVD"). Une métallisation d'aluminium est ensuite réalisée pour former des conducteurs électriques $43_1$ et $43_2$ pour prendre les contacts 44 sur les éléments sensibles piézorésistifs 7 (figure 2d).

Ensuite, comme représenté à la figure 2e, on réalise à partir de la face arrière 10 du substrat 1 des cavités ouvertes 8 par gravure ionique sèche profonde après masquage par une couche de résine épaisse 11.

On peut également réaliser une gravure humide de type TMAH (hydroxyde d'ammonium tétraméthyl), KOH ou EDP (éthylène diamine pyrocatechol), mais dans ce cas une couche de nitrure 11 est utilisée comme couche de masquage.

Dans l'un et l'autre cas, la couche d'oxyde de silicium interfaciale 5 du substrat 1 sert de couche d'arrêt à la gravure.

Cette couche 5 est ensuite éventuellement enlevée par gravure sèche RIE en face arrière, qui est préconisée plutôt que l'utilisation d'une solution chimique d'acide fluoridrique qui peut endommager la face avant du dispositif.

Chaque cavité ouverte ou cuvette 8 présente alors une membrane mince 40 intégrant des piézorésistànces $3_1$ à $3_4$ ou R1 à R4 (correspondant aux zones 44).

Une variante du procédé est représentée en relation avec les figures 4a à 4f. On part d'un substrat Si qui est soumis sur ses deux faces à une oxydation (double oxydation $41_1$, $41_2$, figure 4a). Ensuite on réalise, éventuellement après préamorphisation, l'implantation de B ou de $BF_2$ à travers des ouvertures $45_1$ pour réaliser les piézorésistances $7_1$ (figure 4b). Cette implantation est suivie d'un recuit d'implantation et d'une oxydation thermique pour isoler les résistances ($41_1$, $42_1$, figure 4c). On réalise ensuite des ouvertures dans la couche d'oxyde $41_1$, $42_1$ pour réaliser les contacts $44_1$ par métallisation Al, puis on effectue la gravure des contacts et un recuit de l'Al de manière à obtenir les métallisations ($43_{11}$, $43_{22}$) (figure 4d). On dispose une couche de résine $10_1$ qui est isolée pour ouvrir ensuite l'oxyde de $41_2$ en face arrière (figure 4e). Enfin, on réalise une gravure sèche profonde en face arrière pour former les cavités ouvertes 81 et les membranes $40_1$ (figure 4f). Les cavités 81 (carrées ou rectangulaires) sont délimitées par un fond 91 et quatre bords latéraux 82. D'une manière générale, les étapes de ce procédé sont réalisées de la même façon que pour le procédé des figures 2a à 2c, sauf que le substrat est en Si sans couche d'oxyde enterré.

La configuration proposée s'adapte à n'importe quel système robotisé de dépôt d'échantillons permettant de déposer des gouttes dont le volume n'excède pas quelques nanolitres. A titre d'exemple, des systèmes à dépôt par contact à l'aide de microaiguilles ou à l'aide de systèmes piézoélectriques conviennent.

La matrice de biocapteurs permet de concevoir un système de détection intégré reposant sur la mesure fine de variation de masse consécutive à une hybridation ou à une interaction entre molécules biologiques à l'aide d'un système piézorésistif ou piézoélectrique disposé sur une membrane (ou sur une poutre).

Ce dispositif permet d'obtenir d'un point de vue qualitatif la détection d'interactions entre molécules biologiques, et d'un point de vue quantitatif une mesure de la quantité de molécules ayant interagi, ainsi qu'un suivi de la cinétique de réaction, ceci sans avoir recours à des étapes de marquage des molécules biologiques à l'aide de marqueurs radioactifs ou fluorescents.

L'utilisation de micro et nanotechnologie permet la production en masse et à faible coût de la matrice de biocapteurs. Compte-tenu du principe de mesure de variation de masse, les molécules ne nécessitent pas de marquage préalable. L'utilisation de ces capteurs permet une détection rapide et quantitative ainsi qu'un suivi en temps réel de la cinétique de la réaction intermoléculaire.

La réduction de taille des dispositifs résonants que permet d'obtenir la technique mise en oeuvre, autorise l'obtention d'une fréquence de résonance élevée, typiquement de plusieurs MHz, avec un facteur de qualité élevé conduisant à une augmentation de la sensibilité. De plus, la faible masse de la partie active des microdispositifs les rend d'autant plus sensibles à la moindre variation de masse consécutive à l'appariement d'une espèce complémentaire.

Les mesures peuvent être effectuées dans le vide, et dans ce cas on a recours à des étapes de lavage et de séchage après hybridation. Elles peuvent être également réalisées en milieu liquide, et dans ce cas, l'étape de séchage n'est pas effectuée.

Dans le vide, on privilégie la mesure de variation de résonance ou d'impédance, et dans le liquide la mesure de l'amortissement visqueux.

Du fait que la matrice de biocapteurs comprend un grand nombre de structures résonantes, il est possible d'effectuer une analyse statistique des données si le même dépôt est effectué sur chaque structure ou de travailler simultanément avec plusieurs types de dépôt.

Les principaux avantages de la matrice de biocapteurs selon l'invention sont donc :

1) un faible coût de fabrication grâce à l'utilisation d'une technique de fabrication collective (micro et nanotechnologies),

2) la possibilité de fabriquer de manière collective des structures résonantes, en réseau, de très petites dimensions, pour augmenter la sensibilité et la densité d'intégration,

3) la possibilité de travailler sur de faibles volumes utiles, ce qui réduit le temps nécessaire à l'analyse ainsi que le coût de fabrication de la puce,

4) la possibilité de suivre in situ la cinétique des réactions qui rentrent en jeu,

5) la possibilité de détecter des réactions d'hybridations sans avoir recours à des techniques de marquage de type fluorescence ou de radioactivité,

6) la possibilité d'une réutilisation des structures par simple lavage ou par chauffage à température compatible avec la déshybridation (entre 50 et 60°C),

7) une automatisation de la lecture et un rendu de résultats ultra rapide.

L'invention peut également être mise en oeuvre en réalisant par un procédé connu en soi des éléments sensibles piézoélectriques 54 disposés en des endroits localisés de la surface principale du substrat (voir la figure 3). Les cavités ouvertes 8 sont ensuite réalisées comme indiqué précédemment, pour constituer des structures déformables 40 (membrane, ou poutre encastrée à une ou deux extrémités).

**Revendications**

1. Matrice de biocapteurs apte à la détection d'interactions spécifiques d'oligonucléotides (ADN/ADN; ADN/ARN) ou de protéines (ADN/protéines) ou d'antigènes anticorps et comprenant un substrat en matériau semiconducteur, **caractérisée en ce qu'**elle présente une surface principale plane (4) ainsi que des cavités ouvertes (8), ménagées à partir d'une surface plane (10) opposée à ladite surface plane (4), et dont chacune présente une structure déformable (40, 50) présentant une pluralité d'éléments sensibles qui sont des piézorésistances (44) ou des éléments piézoélectriques (54) disposés entre le fond (9, $9_1$) desdites cavités (8) et la surface plane (4), et qui sont montés en pont de Wheatstone.

2.  Matrice selon la revendication 1, **caractérisée en ce qu'**au moins une structure déformable est une membrane (40, 50).

3.  Matrice selon une des revendications 1 ou 2, **caractérisée en ce qu'**au moins une structure déformable comporte au moins une poutre.

4.  Matrice selon la revendication 2 **caractérisée en ce que** les piézorésistances ont la même résistance et sont situées au milieu de chaque bord d'une membrane carrée ou rectangulaire.

5.  Matrice selon une des revendications précédentes, **caractérisé en ce que** le substrat est en silicium.

6.  Matrice selon la revendication 5, **caractérisée en ce que** le substrat présente une couche enterrée (5) en $SiO_2$.

7.  Matrice selon une des revendications précédentes, **caractérisée en ce que** la surface principale plane (4) présente des métallisations ($43_1$, $43_2$) permettant le raccordement électrique desdits éléments sensibles (44, 54).

8.  Procédé de fabrication d'une matrice de biocapteurs selon une des revendications précédentes, **caractérisé en ce qu'**il met en oeuvre :

    a) la réalisation de dits éléments sensibles (44, 54) en des premiers endroits localisés de la surface principale plane du substrat,
    b) la réalisation de dites cavités (8) à partir de deuxième(s) endroits localisés d'une deuxième surface (10) du substrat qui est opposée à la surface principale plane (4), pour obtenir des structures déformables (40, 50) comportant au moins un dit élément sensible (44, 54).

9.  Procédé selon la revendication 8, **caractérisé en ce que** lesdits éléments sensibles (44) sont piézorésistifs, **en ce que** le substrat est en silicium et a comporte :

    $a_1$) le dépôt d'une couche de masquage (41) sur une première surface du substrat,

    $a_2$) la réalisation d'ouvertures (45) en des premiers endroits localisés de la couche de masquage (41),
    $a_3$) l'implantation d'ions en vue de la réalisation desdits éléments sensibles piézorésistifs (44),

    et **en ce que** b comporte :

    $b_1$) le dépôt d'une couche de masquage (11) sur la deuxième surface (10) du substrat, opposée à la première surface,
    $b_2$) la réalisation d'ouvertures dans les deuxièmes endroits localisés de la couche de masquage (11),
    $b_3$) la réalisation par attaque chimique desdites cavités (8).

10.  Procédé selon la revendication 9, **caractérisé en ce que** le substrat comporte une couche enterrée (5) en silice surmontée d'une couche superficielle monocristalline (6) et **en ce que** a1 comporte le dépôt de ladite couche de masquage (41) sur la surface de la couche superficielle monocristalline (6) qui constitue ladite première surface du substrat et **en ce qu'**en b3, l'attaque est poursuivie au moins jusqu'à la couche enterrée en silice (5) qui forme une couche d'arrêt.

11.  Procédé selon une des revendications 9 ou 10, **caractérisé en ce que** a3 met en oeuvre

    $a_{31}$) une implantation de bore ou de $BF_2$
    $a_{32}$) un recuit thermique

12.  Procédé selon la revendication 11, **caractérisé en ce que** $a_{31}$ est précédé d'une préamorphisation de la surface du substrat auxdits premiers endroits localisés de la couche de masquage.

13.  Procédé selon la revendication 12, **caractérisé en ce que** ladite préamorphisation est réalisée par implantation de Ge.

14.  Procédé selon une des revendications 9 à 13, **caractérisé en ce qu'**il met en oeuvre la réalisation d'électrodes ($43_1$, $43_2$) de prise de contact électrique pour les éléments sensibles piézorésistifs (44).

15.  Procédé selon la revendication 8, **caractérisé en ce que** les éléments sensibles sont piézoélectriques et **en ce que** a comporte : le dépôt sur lesdits premiers endroits localisés d'une couche piézoélectrique (54) suivi d'un recuit de cristallisation.

16.  Procédé selon la revendication 15, **caractérisé en ce qu'**il met en oeuvre la réalisation d'électrodes de prise de contact électrique pour les éléments sensibles piézoélectriques.

**17.** Procédé d'utilisation d'une matrice de biocapteurs selon une des revendications 1 à 8, **caractérisé en ce qu'**il met en oeuvre :

a) une étape préliminaire de contrôle, à l'aide desdits éléments sensibles, de la force d'appui exercée par un dispositif de dépose d'échantillon, sur chacun des biocapteurs et/ou de la durée durant laquelle une force d'appui est appliquée par ledit dispositif de dépose d'échantillons,

b) une étape dynamique de détection au cours de laquelle on mesure les variations de masse des échantillons déposés sur chacun des biocapteurs.

**Claims**

**1.** A biosensor matrix suitable for detecting specific interactions, of oligonucleotides (DNA/DNA; DNA/RNA) or of proteins (DNA/proteins) or of antigens-antibodies and comprising a substrate of semiconductor material, the matrix being **characterized in that** it presents a main plane surface (4) and open cavities (8) formed in a plane surface (10) opposite from said plane surface (4), with each of them having a deformable structure (40, 50) presenting a plurality of sensing elements that are piezoresistive or piezoelectric elements (44 or 54) and that are disposed between the bottoms $(9, 9_1)$ of said cavities (8) and the plane surface (4), in a Wheatstone bridge circuit.

**2.** A matrix according to claim 1, **characterized in that** at least one deformable structure is a membrane (40, 50).

**3.** A matrix according to claim 1 or claim 2, **characterized in that** at least one deformable structure comprises at least one beam.

**4.** A matrix according to claim 2, **characterized in that** the piezoresistive elements have the same resistance and are situated in the middle of each edge of a square or rectangular membrane.

**5.** A matrix according to any preceding claim, **characterized in that** the substrate is made of silicon.

**6.** A matrix according to claim 5, **characterized in that** the substrate presents a buried layer (5) of $SiO_2$.

**7.** A matrix according to any preceding claim, **characterized in that** the main plane surface (4) presents metallizations $(43_1, 43_2)$ enabling electrical connections to be made to said sensing elements (44, 54).

**8.** A method of fabricating a matrix of biosensors according to any preceding claim, the method being **characterized in that** it implements:

a) making said sensing elements (44, 54) in first localized locations of the main plane surface of the substrate; and

b) making said cavities (8) at second localized locations in a second surface (10) of the substrate which is opposite from the main plane surface (4), in order to obtain deformable structures (40, 50), each including at least one said sensing element (44, 54).

**9.** A method according to claim 8, **characterized in that** said sensing elements (44) are piezoresistive, **in that** the substrate is made of silicon, and **in that** step a) comprises:

$a_1$) depositing a masking layer (41) on a first surface of the substrate;

$a_2$) making openings (45) in first localized locations of the masking layer (41); and

$a_3$) implanting ions in order to make said piezoresistive sensing elements (44);

and **in that** step b) comprises:

$b_1$) depositing a masking layer (11) on the second surface (10) of the substrate, opposite from its first surface;

$b_2$) making openings at second localized locations in the masking layer (11); and

$b_3$) making said cavities (8) by chemical etching.

**10.** A method according to claim 9, **characterized in that** the substrate includes a buried layer (5) of silica surmounted by a single crystal surface layer (6), and **in that** step $a_1$) comprises depositing said masking layer (41) on the surface of the single crystal surface layer (6) which constitutes said first surface of the substrate, and **in that** in step $b_3$) etching is continued at least as far as the buried silica layer (5) which forms a stop layer.

**11.** A method according to claim 9 or claim 10, **characterized in that** step $a_3$) implements:

$a_{31}$) implanting boron or $BF_2$; and

$a_{32}$) thermal annealing.

**12.** A method according to claim 11, **characterized in that** step $a_{31}$) is preceded by pre-amorphization of the surface of the substrate at said first localized locations of the masking layer.

**13.** A method according to claim 12, **characterized in that** said pre-amorphization is performed by implanting Ge.

**14.** A method according to any one of claims 9 to 13, **characterized in that** it includes making electrodes ($43_1$, $43_2$) for making electrical contact with the piezoresistive sensing elements (44).

**15.** A method according to claim 8, **characterized in that** the sensing elements are piezoresistive and **in that** step a) comprises: depositing a piezoelectric layer (54) at said first localized locations followed by crystallization annealing.

**16.** A method according to claim 15, **characterized in that** it includes providing electrodes for making electrical contact with the piezoelectric sensing elements.

**17.** A method of using a biosensor matrix according to any one of claims 1 to 8, the method being **characterized in that** it implements:

a) a preliminary step of using said sensing elements to control the bearing force exerted by a sample-depositor device against each of the biosensors and/or the length of time during which a bearing force is applied by said sample-depositor device; and

b) a dynamic detection step during which variations in the mass of the samples deposited on each of the biosensors are measured.

**Patentansprüche**

**1.** Biosensormatrix, die zur Detektion von spezifischen Wechselwirkungen von Oligonucleotiden (DNA/DNA; DNA/RNA) oder Proteinen (DNA/Proteinen) oder von Antigenen-Antikörpern fähig ist und ein Substrat aus Halbleitermaterial umfasst, **dadurch gekennzeichnet, dass** sie eine flache Hauptoberfläche (4) sowie offene Kavitäten (8) aufweist, welche ausgehend von einer flachen Oberfläche (10), die der flachen Oberfläche (4) gegenüberliegt, angeordnet sind und von denen jede eine verformbare Struktur (40, 50) aufweist, die eine Vielzahl von empfindlichen Elementen zeigt, die piezoelektrische Widerstände (44) oder piezoelektrische Elemente (54), die zwischen dem Boden (9, $9_1$) der Kavitäten (8) und der flachen Oberfläche (4) angeordnet sind und die als Wheatstone-Brücke montiert sind, sind.

**2.** Matrix gemäß Anspruch 1, **dadurch gekennzeichnet, dass** wenigstens eine verformbare Struktur eine Membran (40, 50) ist.

**3.** Matrix gemäß einem der Ansprüche 1 oder 2, **dadurch gekennzeichnet, dass** wenigstens eine verformbare Struktur wenigstens einen Träger umfasst.

**4.** Matrix gemäß Anspruch 2, **dadurch gekennzeichnet, dass** die piezoelektrischen Widerstände den selben Widerstand haben und sich in der Mitte jedes Randes einer quadratischen oder rechteckigen Membran befinden.

**5.** Matrix gemäß einem der vorangehenden Ansprüche, **dadurch gekennzeichnet, dass** das Substrat aus Silicium ist.

**6.** Matrix gemäß Anspruch 5, **dadurch gekennzeichnet, dass** das Substrat eine vertiefte Schicht (5) aus $SiO_2$ aufweist.

**7.** Matrix gemäß einem der vorangehenden Ansprüche, **dadurch gekennzeichnet, dass** die flache Hauptoberfläche (4) Metallisierungen ($43_1$, $43_2$) aufweist, die die elektrische Verbindung der empfindlichen Elemente (44, 54) erlauben.

**8.** Verfahren zur Herstellung einer Biosensormatrix gemäß einem der vorangehenden Ansprüche, **dadurch gekennzeichnet, dass** es durchführt:

a) Herstellung der empfindlichen Elemente (44, 54) an ersten Stellen, die an der flachen Hauptoberfläche des Substrats lokalisiert sind,

b) Herstellung der Kavitäten (8) ausgehend von zweiten Orten, die an einer zweiten Oberfläche (10) des Substrats lokalisiert sind, die der flachen Hauptoberfläche (4) gegenüberliegt, um verformbare Strukturen (40, 50) zu erhalten, die wenigstens ein empfindliches Element (44, 54) umfassen.

**9.** Verfahren gemäß Anspruch 8, **dadurch gekennzeichnet, dass** die empfindlichen Elemente (44) piezoresistiv sind, dass das Substrat aus Silicium ist und a umfasst:

$a_1$) Abscheidung einer Maskierungsschicht (41) auf einer ersten Oberfläche des Substrats,

$a_2$) Herstellung von Öffnungen (45) an ersten Stellen, die in der Maskierungsschicht (41) lokalisiert sind,

$a_3$) Implantierung von Ionen im Hinblick auf die Herstellung der empfindlichen piezoresistiven Elemente (44),

und dass b umfasst:

$b_1$) Abscheidung einer Maskierungsschicht (11) auf der zweiten Oberfläche (10) des Substrats, die der ersten Oberfläche gegenüberliegt,

$b_2$) Herstellung von Öffnungen an den zweiten Stellen, die in der Maskierungsschicht (11) lokalisiert sind,

$b_3$) Herstellung der Kavitäten (8) durch chemischen Angriff.

10. Verfahren gemäß Anspruch 9, **dadurch gekennzeichnet, dass** das Substrat eine vertiefte Schicht (5) aus Siliciumdioxid umfasst, die von einer monokristallinen Oberflächenschicht (6) überdeckt wird, und dass a1 die Abscheidung der Maskierungsschicht (41) auf der Oberfläche der monokristallinen Oberflächenschicht (6), welche die erste Oberfläche des Substrats bildet, umfasst, und dass in b3 der Angriff wenigstens bis zur tieferliegenden Schicht aus Siliciumdioxid (5), die eine Stoppschicht bildet, fortgesetzt wird.

11. Verfahren gemäß einem der Ansprüche 9 oder 10, **dadurch gekennzeichnet, dass** a3 durchführt:

   $a_{31}$) eine Implantierung von Bor oder $BF_2$,
   $a_{32}$) Glühen.

12. Verfahren gemäß Anspruch 11, **dadurch gekennzeichnet, dass** $a_{31}$ eine Voramorphisierung der Oberfläche des Substrats an den Stellen, die in der Maskierungsschicht lokalisiert sind, vorausgeht.

13. Verfahren gemäß Anspruch 12, **dadurch gekennzeichnet, dass** die Voramorphisierung durch Implantierung von Ge erfolgt.

14. Verfahren gemäß einem der Ansprüche 9 bis 13, **dadurch gekennzeichnet, dass** es die Herstellung von Elektroden ($43_1$, $43_2$) für den elektrischen Kontakt für die empfindlichen piezoresistiven Elemente (44) durchführt.

15. Verfahren gemäß Anspruch 8, **dadurch gekennzeichnet, dass** die empfindlichen Elemente piezoelektrisch sind und dass a umfasst: die Abscheidung einer piezoelektrischen Schicht (54) an den ersten Orten, gefolgt von einem Kristallisationsglühen.

16. Verfahren gemäß Anspruch 15, **dadurch gekennzeichnet, dass** es die Herstellung von Elektroden für den elektrischen Kontakt für die empfindlichen piezoelektrischen Elemente durchführt.

17. Verfahren der Verwendung einer Biosensormatrix gemäß einem der Ansprüche 1 bis 8, **dadurch gekennzeichnet, dass** es umfasst:

   a) eine vorangehende Stufe der Kontrolle der Auflagekraft, die durch eine Probenauftragungsvorrichtung auf jeden der Biosensoren und/oder der Dauer, während eine Auflagekraft durch die Probenauftragungsvorrichtung angewendet wird, mit Hilfe der empfindlichen Elemente,
   b) eine dynamische Stufe der Detektion, im Verlauf der man die Massenveränderungen der aufgetragenen Proben für jeden der Biosensoren misst.

## FIG.1a

## FIG.1b

FIG.2a

FIG.2b

FIG.2c

FIG.2d

FIG.2e

FIG.3

FIG.1d

FIG.1c

FIG.4a

FIG.4b

FIG.4c

FIG.4d

FIG.4e

FIG.4f

**EP 1 381 852 B1**

**RÉFÉRENCES CITÉES DANS LA DESCRIPTION**

**Documents brevets cités dans la description**

- US 5719324 A
- US 6054277 A
- US 5807758 A